# EUROPÄISCHE PATENTSCHRIFT

(11) **EP 1 443 619 B1**
(45) Veröffentlichungstag und Bekanntmachung des Hinweises auf die Patenterteilung: **14.06.2006**
(21) Anmeldenummer: 03450029.8
(22) Anmeldetag: 29.01.2003
(51) Int. Cl.: H02G 1/12

(54) **Abisolieren von Flachleitern**
Stripping of flat conductors
Dénudage de conducteurs plats

(43) Veröffentlichungstag der Anmeldung: 04.08.2004
(73) Patentinhaber: I & T Innovation Technology Entwicklungs- und Holding Aktiengesellschaft, 7011 Siegendorf (AT)
(72) Erfinder: Dietrich, Jörn, 71296 Heimsheim (DE)
(74) Vertreter: Wildhack, Helmut

(56) Entgegenhaltungen:
- DE-A- 10 064 696
- US-A- 4 931 616
- PATENT ABSTRACTS OF JAPAN vol. 2002, no. 05, 3. Mai 2002 (2002-05-03) & JP 2002 027626 A (AUTO NETWORK GIJUTSU KENKYUSHO:KK;SUMITOMO WIRING SYST LTD; SUMITOMO E), 25. Januar 2002 (2002-01-25)
- PATENT ABSTRACTS OF JAPAN vol. 016, no. 204 (E-1202), 15. Mai 1992 (1992-05-15) & JP 04 033510 A (MITSUBISHI ELECTRIC CORP), 4. Februar 1992 (1992-02-04)
- PATENT ABSTRACTS OF JAPAN vol. 013, no. 386 (E-812), 25. August 1989 (1989-08-25) & JP 01 136396 A (FUJITSU LTD), 29. Mai 1989 (1989-05-29)

## Beschreibung

Die Erfindung betrifft das Abisolieren von Flachleitern mit Hilfe eines Lasers. Flachleiter, sogenannte FFCs, werden insbesondere in der Automobilindustrie zur Herstellung von Kabelbäumen, zunehmend verwendet, da sie im Gegensatz zu Rundleitern durch Automaten manipuliert werden können und daher insbesondere bei der Herstellung von Kabelbäumen für Kraftfahrzeuge, aber auch bei anderen industriellen Anwendungen, günstiger sind als Rundleiter.

Prinzipiell sind zwei Arten von FFCs zu unterscheiden, die laminierten und die extrudierten. Die laminierten FFCs bestehen aus elektrischen Leiterbahnen, zumeist aus Kupfer, die parallel zueinander zwischen zwei Folien geklebt sind und so nach außen und untereinander isoliert sind. Die Folien können mehrlagig ausgebildet sein oder es können mehr als zwei Folien verwendet werden.

Die extrudierten FFCs bestehen aus Leiterbahnen, die durch spezielle Extrusionsmaschinen geführt werden, wobei ein elektrisch isolierendes Extrudat um sie herum gegossen bzw. gespritzt wird, so dass die einzelnen Leiterbahnen durch das Extrudat nach außen und gegeneinander isoliert sind.

Die vorliegende Erfindung betrifft beide Arten von FFCs.

In beiden Fällen können die Querschnitte der eigentlichen Leiterbahnen rund, oval, rechteckig oder mit anderer Form versehen sein.

Die Verwendung von FFCs, welcher Art auch immer, ermöglicht es, Abzweigungen bzw. Verbindungen so herzustellen, dass in den zu verbindenden FFCs an den gewünschten Stellen das Isolationsmaterial entfernt wird, man sagt: "Es werden Fenster geschaffen", und die FFCs passend mit ihren Fenstern übereinandergelegt werden. Die nun freiliegenden und in engem Abstand voneinander befindlichen bzw. einander bereits berührenden Leiterbahnen werden miteinander z.B. durch Löten, Schweißen, etc. verbunden und die Isolierung nach außen zumeist durch Klebemassen, Klebefilme oder dgl., wieder gesichert.

Darüber hinaus kann es auch notwendig sein, im Endbereich jedes FFCs Abisolierungen vorzunehmen, um Stecker, Kontakte oder dgl. aufbringen zu können.

Es hat sich als notwendig erwiesen, auch im erstgenannten Falle der Fensterbildung die Leiterbahnen meist beidseits freizulegen, da nur dann eine mechanisch stabile und elektrisch zuverlässige Verbindung zwischen den übereinander liegenden Leiterbahnen geschaffen werden kann.

Beim Absisolieren durch fensterbildung muss darauf geachtet werden, dass die Geometrie dieser Fenster möglichst genau der gewünschten Geometrie entspricht und dass das isolierende Material möglichst vollständig entfernt wird. Nach der Schaffung des Fensters müssen die Leiterbahnen in einem Zustand und hier insbesondere Oberflächenzustand vorliegen, der eine sicher elektrisch leitende und bevorzugt auch mechanisch stabile Verbindung der übereinander liegenden Leiterbahnen ohne aufwendige Vorbereitung gestattet.

Die bisher verwendeten Verfahren arbeiten mechanisch und bestehen aus einer Art Kombination von Stanztechnik und Abschälvorgang im bereits bis zur Leiterbahn ausgestanzten Bereich. Aufgrund der unvermeidlichen Herstellungstoleranz, insbesondere bei den extrudierten FFCs, bei denen die Leiterbahnen im erstarrenden Extrudat ohne eigene Führung und Justierung solange "schwimmen", bis das Extrudat erstarrt ist, führt dies zu Problemen mit an den Leiterbahnen verbleibenden Extrudatresten, die zu Beschädigungen der Leiterbahnen an den Stellen führen, an denen die Leiterbahn exzentrisch im Extrudat vorliegt.

Bei Versuchen, die Isolation mittels Lasers zu entfernen, stellte sich heraus, dass dies zu Oberflächeneigenschaften der Leiterbahnen führt, die eine nachfolgende aufwendige naßchemische Behandlung notwendig machten und so für Stückzahlen und Taktraten, die über einen Probebetrieb hinausgehen, unbrauchbar waren.

Man darf dabei nicht vergessen, dass eine derartige Behandlung mit flüssigen Chemikalien eine Zwischenstation im Produktionsablauf notwendig macht, bei der die Chemikalien unter einer Abzugshaube aufgebracht und nach ihrem Einwirken wieder entfernt werden, dass es notwendig ist, die entsprechenden Stellen der durch die Station geführten FFCs zu trocknen und erneut zu überprüfen und dass die verwendeten Chemikalien nicht nur hereitgestellt, sondern wieder aufbereitet und zu guter Letzt entsorgt werden müssen. Dazu kommt, dass es prinzipiell unangenehm und unerwünscht ist, mit derartigen Chemikalien in einem Produktionsprozess zwischen mechanischen, elektrischen und laserbestückten Bearbeitungsstationen zu hantieren.

Die Erfindung zielt darauf ab, ein Verfahren anzugeben, das die genannten Nachteile nicht aufweist, sondern die Herstellung von Fenstern in FFCs auf zuverlässige und an das gesamte Herstellungsverfahren angepasste Weise zu erreichen, wobei auf eine nachfolgende Behandlung der Oberflächen der Leiterbahnen verzichtet werden kann und die mit den Fenstern versehenen FFCs entweder unmittelbar weiter verarbeitet werden oder einer Station zugeführt werden, in denen die Oberflächen der freiliegenden Leiterbahnabschnitte passend beschichtet werden, um auch bei nachfolgender längerer Lagerung eine elektrisch einwandfreie leitende und zuverlässig zu verlötende bzw. zu verschweißende Oberfläche zu schaffen, worauf die so fertiggestellten FFCs auf beliebige Weise gelagert werden können.

Ein Verfahren zum Abisolieren eines Bereiches eines Flachleiters gemäβ dem Oberbegriff des Anspruchs 1 ist der US 4 931 616 A zu entnehmen.

Erfindungsgemäß werden die obengenannten Ziele dadurch erreicht, dass der zur Schaffung der Fenster eingesetzte Laser, bevorzugt ein CO₂-Laser, nur den Randbereich des Isolationsfensters bearbeitet, und dass in einem nachfolgenden Schritt die Isolationsreste in der Fenstermitte entfernt werden.

Dazu können mechanische, thermische oder andere physikalische Verfahren eingesetzt werden. Vorteilhaft dabei ist, dass die Isolationsschicht in diesem zentralen Fensterbereich noch ihre volle Schichtdicke besitzt und so bessere Möglichkeiten zu ihrer Entfernung bietet.

Zum Beispiel kann zur Entfernung der Isolierung in zentralen Bereich des Fensters der FFC über eine Rolle mit einem kleinen Durchmesser, bevorzugt zwischen 2,5 und 30 mm abgerollt werden, wobei an der Oberfläche des FFC ein Keil, der federnd gelagert sein kann, nach Art eines Rakelmessers, in die Umrandung des Isolationsfensters eingreift und die Isolierung wegschiebt bzw. anhebt und damit entfernt. Dadurch wird in der Fenstermitte die metallisch blanke Oberfläche des Kupfers ohne jede Beeinträchtigung freigelegt, die für die nachfolgenden Verarbeitungsprozesse nicht weiter bearbeitet werden muss.

Es ist weiterhin möglich, anstelle des Kcils eine bezüglich der FFC bewegte Bürste (z.B. rotierende Bürste) einzusetzen, wobei die Drehachse der Bürste parallel zu der Achse der Rolle liegt. Die Drehrichtung der Bürste sollte vorzugsweise entgegen der Vorschubbewegung der FFC auf dem Berührungsradius sein.

Auf diese Weise werden tatsächlich die Probleme der vorbekannten Verfahren vermieden und die erfindungsgemäßen Ziele erreicht.

Ein weiterer Vorteil des erfindungsgemäßen Verfahrens ist die Reduzierung der Bearbeitungszeit, da nur die Umrandung der Isolationsfensters mit dem Laser abgefahren werden muss und nicht die gesamte Fläche des Isolationsfensters und da der Rest der Isolierung durch das Messer rasch und nahezu unabhängig von der Größe des Fensters abisoliert wird.

Die Erfindung wird im folgenden an Hand der Zeichnung näher erläutert. Dabei zeigt
die Fig. 1 einen rein schematischen Schnitt durch ein FFC nach dem Abtragen des Fensterrandes mittels Laser,
die Fig. 2 eine rein schematische Draufsicht und
die Fig. 3 eine schematische Darstellung des erfindungsgemäßen Abschälvorganges.

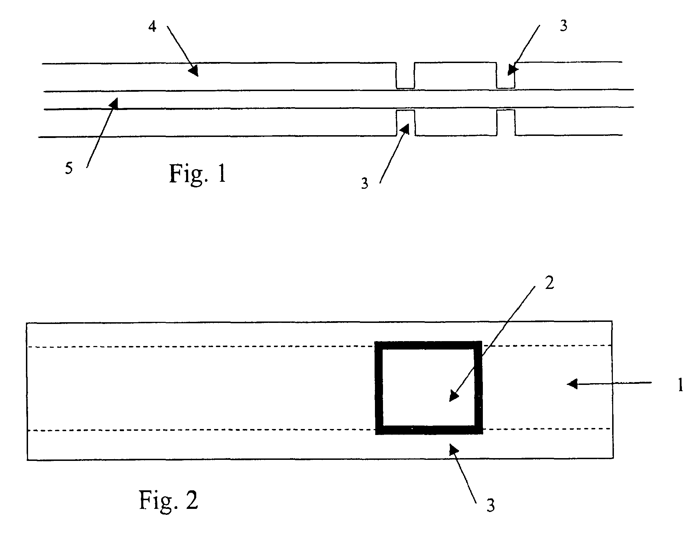

Wie aus Fig. 1 und 2 hervorgeht, wird auf an sich bekannte Weise mittels eines Lasers, bevorzugt eines CO₂-Lasers, der Randbereich 3 eines im FFC 1 auszubildenden Fensters 2 hergestellt. Dabei wird im wesentlichen das gesamte Isolationsmaterial 4 durch das der eigentliche, zumeist aus Kupfer oder einer Kupferlegierung bestehende Leiter 5 elektrisch isoliert wird, abgetragen, und dies zu beiden Seiten des FFC 1. In Fig. 1 ist andeutungsweise ein Restbereich des Isolationsmaterials 4 im Bereich des Rahmens 3 eingezeichnet.

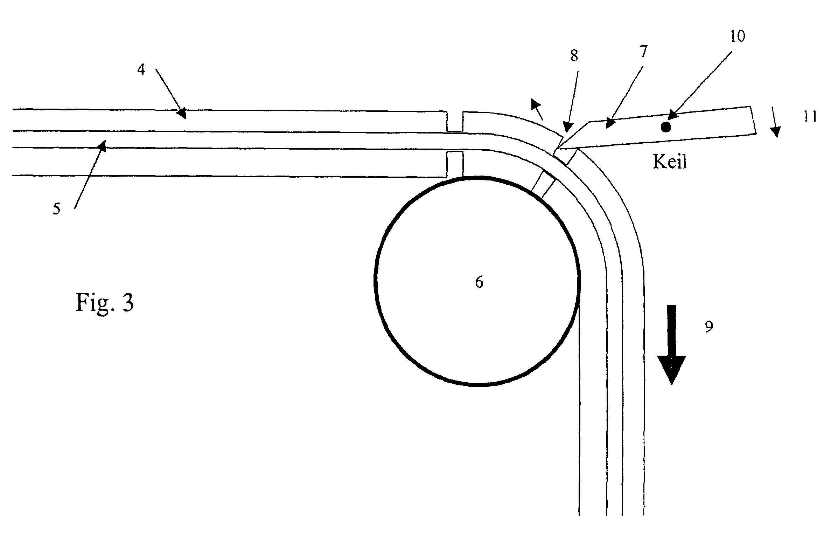

Die Fig. 3 zeigt rein schematisch die Entfernung des Isolationsmaterials im Bereich des eigentlichen Fensters 2, die folgendermaßen erfolgt: Der FFC 1 wird in straff geführter Form der Länge nach über eine Rolle 6 geführt, deren Durchmesser bevorzugt maximal dem 5 bis 60 -fachen der Dicke des FFC beträgt. In dem Bereich, in dem die Grenzschicht zwischen Isolationsmaterial 4 und Leiter 5 bereits gekrümmt sind, wird ein Keil, bzw. Messer 7, dessen Breite (das ist seine Erstreckung quer zur Längsachse des FFC's und parallel zur Krümmungsachse der Rolle 6) zumindest im wesentlichen gleich ist der Breite des Fensters 2, aber keinesfalls größer ist als die äußere Breite des Fensterrahmens 3, mit der Schneide voran in den Grenzbereich zwischen dem Isolationsmaterial 4 und dem Leiter 5 gebracht und bewirkt bei Weiterbewegung des FFC 1 in Richtung des Pfeiles 9, daß das Isolationsmaterial im Bereich des Fensters 2 richtiggehend abgeschält wird, wodurch die blanke und unmittelbar weiter zu behandelnde bzw. direkt zu verbindende Oberfläche des Leiters 5 im Bereich des Fensters 2 freigelegt wird.

Da es in den meisten Anwendungsfillen notwendig ist, den Leiter 5 im Bereich des Fensters 2 beidseitig freizulegen, ist dies in den Fig. 1 und 3 dargestellt, die Entfernung des Isolationsmaterials auf der in Fig. 3 innen liegenden Seite des Fensters 2 erfolgt völlig analog zur dargestellten Entfernung des äußeren Bereiches, entweder bei einer nachfolgenden Bearbeitungsstation im Falle der kontinuierlichen Arbeitsweise oder durch erneutes Durchlaufen der dargestellten Arbeitsstation mit umgekehrt aufgelegtem FFC bei schrittweiser Herstellung.

Im dargestellten Ausführungsbeispiel weist der FFC 1 einen einzigen Leiter 5 auf, selbstverständlich ist in den meisten praktischen Anwendungsfällen dies nicht der Fall, sondern der FFC weist mehrere nebeneinander liegenden und voneinander elektrisch isolierte Leiter auf, von denen auch üblicherweise nur einzelne mittels Fenstern zugänglich gemacht werden sollen. Durch diese Änderung der Geometrie bzw. der Abmessungen ändert sich aber überhaupt nichts an der Durchführung des erfindungsgemäßen Verfahrens.

Es ist in Fig. 3 das Messer 7 als einfaches geradliniges keilförmiges Instrument dargestellt, es kann selbstverständlich in Abhängigkeit von den geometrischen Bedingungen die Form des Messers 7 von der dargestellten Form abweichen. Auch ist die in Fig. 3 dargestellte einfache Kippbewegung des Messers 7 um die Achse 10 in Richtung des Pfeiles 1 bzw. in Gegenrichtung nicht zwingend notwendig, es ist auch eine lineare oder eine kombinierte Dreh- und Schiebebewegung beim Zustellen bzw. Abziehen des Messers 7 möglich.

Schließlich kann statt der Rolle 6 eine feststehende, abgerundete Kante verwendet werden, über die der FFC 1 gezogen wird. Vorteilhaft bei der Verwendung der Rolle 6 ist dem gegenüber, daß die Reibung beim normalen Vorschub und damit die Dehnung des FFC wcsentlich verringert wird, wobei während des Schälvorganges die Rolle synchron zur Vorschubbewegung 9 des FFC angetrieben werden kann, um eine möglichst präzise Positionierung und Führung sicherzustellen. Es kann dabei die Oberfläche der Rolle so ausgebildet sein, daß sie gegenüber dem Isolationsmaterial des FFCI eine hohe Reibung aufweist und auf diese Weise die Positionierung bestmöglich unterstützt. Im Gegensatz dazu ist bei Verwenden einer feststehenden, abgerundeten, Kante eine möglichst glatte, reibungsarme Oberfläche bezüglich des Materials des FFC eine Grundbedingung.

## Patentansprüche

1. Verfahren zum Abisolieren eines Bereiches, eines sogenannten Fensters, eines Flachleiters, eines sogenannten FFC, mittels Laser, **dadurch gekennzeichnet, dass** der zur Schaffung des Fensters eingesetzte Laser, bevorzugt ein CO₂-Laser, nur den Randbereich des Fensters bearbeitet, und dass in einem nachfolgenden Schritt die Isolationsreste im Fensterinneren entfernt werden.

2. Verfahren nach Anspruch 1, **dadurch gekennzeichnet, dass** die Isolationsreste im Fensterinneren mittels mechanischer, thermischer oder anderer physikalischen Verfahren entfernt werden.

3. Verfahren nach Anspruch 2, **dadurch gekennzeichnet, dass** der FFC über eine Rolle (6) mit kleinen Durchmesser, bevorzugt zwischen dem 5-fachen und dem 60-fachen der Stärke des FFC, abgerollt wird, und dass an der Oberfläche des FFC ein Keil (7) nach Art eines Rakelmessers in den vom Laser freigelegten Randbereich des Fensters eingreift und die Isolierung (4) wegschiebt bzw. anhebt und damit entfernt.

4. Verfahren nach Anspruch 3, **dadurch gekennzeichnet, dass** der Keil (7) um eine Achse (10), die zur Achse der Rolle (6) parallel verläuft, schwenkbar ist.

5. Verfahren nach Anspruch 2, **dadurch gekennzeichnet, dass** der FFC über eine Rolle (6) mit kleinen Durchmesser, bevorzugt zwischen dem 5-fachen und dem 60-fachen der Stärke des FFC, abgerollt wird, und dass an der Oberfläche des FFC eine Bürste in den vom Laser freigelegten Randbereich des Fensters eingreift und die Isolierung (4) wegschiebt bzw. anhebt und damit entfernt.

6. Verfahren nach Anspruch 5, **dadurch gekennzeichnet, dass** die Bürste um eine Achse, die zur Achse der Rolle (6) parallel verläuft, drehbar ist.

7. Verfahren nach Anspruch 6, **dadurch gekennzeichnet, dass** die Drehrichtung der Bürste im Kontaktbereich mit dem FFC der Vorschubbewegung des FFC entgegengesetzt ist.

## Claims

1. Method for stripping a region, a so-called window, of a flat conductor, a so-called FFC, by means of a laser, **characterized in that** the laser used to make the window, preferably a CO₂ laser, processes only the edge region of the window, and **in that** the remaining insulation inside the window is removed in a subsequent step.

2. Method according to Claim 1, **characterized in that** the remaining insulation inside the window is removed by means of mechanical, thermal or other physical methods.

3. Method according to Claim 2, **characterized in that** the FFC is rolled over a roller (6) with a small diameter, preferably between 5 times and 60 times the thickness of the FFC, and **in that** a wedge (7) engages in the manner of a doctor blade on the surface of the FFC in the window's edge region exposed by the laser, and displaces or lifts and thereby removes the insulation (4).

4. Method according to Claim 3, **characterized in that** the wedge (7) can be tilted about an axis (10) which extends parallel to the axis of the roller (6).

5. Method according to Claim 2, **characterized in that** the FFC is rolled over a roller (6) with a small diameter, preferably between 5 times and 60 times the thickness of the FFC, and **in that** a brush engages on the surface of the FFC in the window's edge region exposed by the laser, and displaces or lifts and thereby removes the insulation (4).

6. Method according to Claim 5, **characterized in that** the brush can be tilted about an axis which extends parallel to the axis of the roller (6).

7. Method according to Claim 6, **characterized in that** the rotation direction of the brush in the region of contact with the FFC is opposite to the forward movement of the FFC.

## Revendications

1. Procédé pour dénuder une zone, ce que l'on appelle une fenêtre, un conducteur plat, ce que l'on appelle un FFC, au moyen d'un laser, **caractérisé en ce que** le laser utilisé pour créer la fenêtre, de préférence un laser au CO₂ ne traite que la zone du bord de la fenêtre et **en ce que**, dans une étape suivante, les résidus d'isolant à l'intérieur de la fenêtre sont retirés.

2. Procédé selon la revendication 1, **caractérisé en ce que** les résidus d'isolant à l'intérieur de la fenêtre sont retirés à l'aide de processus mécaniques, thermiques ou d'autres procédés physiques.

3. Procédé selon la revendication 2, **caractérisé en ce que** l'on déroule le FFC sur un rouleau (6) de petit diamètre, de préférence représentant entre 5 fois et 60 fois l'épaisseur du FFC, et **en ce que**, à la surface du FFC, un coin (7) du type en lame de racle est engagé dans la zone de bord de la fenêtre dégagée par le laser et repousse ou soulève l'isolant (4) et le retire de la sorte.

4. Procédé selon la revendication 3, **caractérisé en ce que** le coin (7) peut pivoter autour d'un axe (10), qui s'étend parallèlement à l'axe du rouleau (6).

5. Procédé selon la revendication 2, **caractérisé en ce que** l'on déroule le FFC sur un rouleau (6) de petit diamètre, de préférence représentant entre 5 fois et 60 fois l'épaisseur du FFC, et **en ce que**, à la surface du FFC, une brosse est engagée dans la zone de bord de la fenêtre dégagée par le laser et repousse ou soulève l'isolant (4) et le retire de la sorte.

6. Procédé selon la revendication 5, **caractérisé en ce que** la brosse peut tourner autour d'un axe, qui s'étend parallèlement à l'axe du rouleau (6).

7. Procédé selon la revendication 6, **caractérisé en ce que** le sens de rotation de la brosse dans la zone de contact avec le FFC est opposé au mouvement d'avancement du FFC.
